# EUROPEAN PATENT APPLICATION

(11) **EP 2 518 785 A2**
(43) Date of publication of application: **31.10.2012**
(21) Application number: 12164288.8
(22) Date of filing: 16.04.2012
(51) Int. Cl.: H01L 33/50

(54) **Light emitting device and illumination device using the same**

(30) Priority: 27.04.2011 JP 2011098920
(71) Applicant: Panasonic Corporation, Osaka 571-8501 (JP)
(72) Inventor: Yokotani, Ryoji, Hirakata, Osaka (JP)
(74) Representative: Rüger, Barthelt & Abel

(57) **Abstract**

[Summary]

[Object] In a light emitting device using a solid-state light emitting element (LED), to be able to broaden light distribution of exit light, easily control the light distribution, and make it difficult for light unevenness to occur.

[Means for Settlement] A light emitting device 1 is provided with: an LED 2; and a wavelength converting member 4 that is adapted to contain a phosphor in a transparent resin member that covers an emission surface of the LED 2. The wavelength converting member 4 is, in a vertical cross-sectional view, formed so as to have an upward thickness thicker than a thickness in a lateral direction of the LED 2 and also have an apex part 40 in a light lead-out direction of the LED 2. According to such a configuration, in the vertical cross-sectional view of the wavelength converting member 4, an amount of light traveling in the lateral direction of the LED 2 is larger than an amount of light traveling upward, so that a light distribution curve becomes a so-called batwing type, and therefore light distribution can be broadened. Also, an amount of light traveling toward a reflector 8 in the lateral direction is increased to therefore make it easy to control the light distribution. Further, directionality is reduced, and therefore when the light emitting device 1 is incorporated in an illumination device 10, light unevenness can be made difficult to occur.

## Description

### [Field of the Invention]

The present invention relates to a light emitting device using a plurality of solid-state light emitting elements as a light source and an illumination device using the same.

### [Background Art]

A light emitting diode (hereinafter referred to as an LED) is paid attention as a light source for illumination device, which replaces an incandescent light or a fluorescent light, because it can emit high luminance light with low power and has a longer life. However, an LED single body has a low light amount as compared with the fluorescent light, and therefore in a typical illumination device using an LED as a light source, a light emitting device provided with a plurality of LEDs is used.

As an LED package for this sort of light emitting device, there is known an LED package that realizes white light by, for example, covering a yellow phosphor layer on an LED chip that emits blue light, and thereby mixing the blue light and yellow light (see, for example, Patent Literature 1). Also, as illustrated in Fig. 10 (a), there is known an LED package 101 that covers an LED chip with a phosphor-containing resin layer 104 that is formed in a hemispherical shape (see, for example, Patent Literature 2). Further, as illustrated in Fig. 11 (a), there is known an illumination device 110 in which a plurality of LED packages 101 each having a hemispherical shaped transparent resin part 104 are arranged, and in front of the LED packages 101, a diffusion transmission panel 107 is closely arranged.

### [Conventional Technique Document]

### [Patent Literature]

[Patent Literature 1] JPA 2011-14695
[Patent Literature 1] JPA 2008-135707

### [Disclosure of the Invention]

### [Problems to be solved by the Invention]

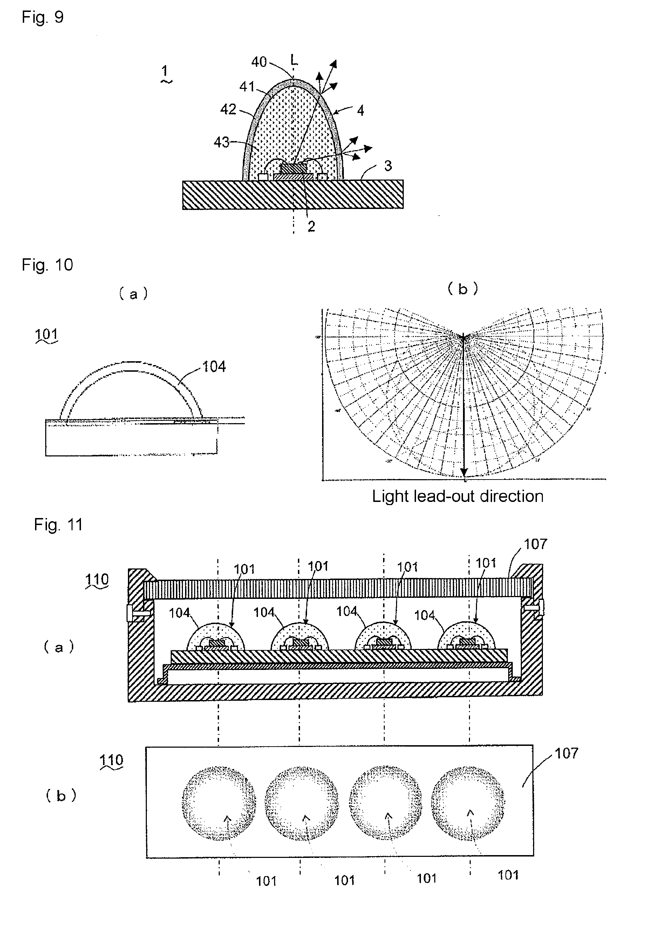

However, in the light emitting device as disclosed in any of above Patent Literatures 1 and 2, a light emitting surface of the yellow phosphor layer mounted in the LED package is formed in a planar or hemispherical shape, and therefore as illustrated in Fig. 10 (b), distribution of emitted light has high directionality in a light lead-out direction. That is, a light amount toward a front direction of the LED package is increased, whereas light amounts toward peripheral directions are decreased. For this reason, even if a reflecting mirror is provided so as to cover the LED package, an amount of light entering the reflecting mirror is decreased, and therefore it is difficult to control the light distribution.

Also, in the above-described illumination device 110, luminance in positions on the diffusion transmission panel 107, which are just above the LED packages 101, is increased. As a result, as illustrated in Fig. 11 (b), luminance distribution on the light emitting surface (diffusion transmission panel 107) of the illumination device becomes nonuniform, which may give rise to a sense of grains due to the light source, and further cause glare.

The present invention is one that solves the above problems, and has an object to provide a light emitting device that can broaden light distribution of emitted light, easily controls the light distribution, and is unlikely to give rise to light unevenness, and an illumination device using the same.

### [Means adapted to solve the Problems]

In order to solve the above problems, a light emitting device according to the present invention is provided with: a solid-state light emitting element; and a wavelength converting member that is adapted to contain a phosphor in a transparent resin member that covers a light emission surface of the solid-state light emitting element, wherein the wavelength converting member is, in a vertical cross-sectional view, formed so as to have an upward thickness thicker than a thickness in a lateral direction of the solid-state light emitting element and also have an apex part in a light lead-out direction of the solid-state light emitting element.

In the above light emitting device, preferably, the wavelength converting member is, in the vertical cross-sectional view, formed in a vertically-long convex shape.

In the above light emitting device, preferably, the wavelength converting member is, in the vertical cross-sectional view, formed in a vertically-long triangular shape.

In the above light emitting device, preferably, the wavelength converting member is, in a top view, formed in a circular shape.

In the above light emitting device, preferably, the wavelength converting member is, in a top view, formed in an elliptical shape.

In the above light emitting device, preferably, the wavelength converting member has a concave portion on a surface facing to the solid-state light emitting element and is formed as a thin member having a uniform thickness, and in the concave portion, a transparent resin is filled.

In the above light emitting device, preferably, the thin member is made of phosphor-containing resin that is coated or molded into a cap shape.

Preferably, the above light emitting device is used for an illumination device.

### [Effects of the Invention]

According to the light emitting device of the present invention, in the vertical cross-sectional view of the wavelength converting member, an amount of light traveling in the lateral direction of the solid-state light emitting element is larger than an amount of light traveling upward, so that a light distribution curve becomes a so-called batwing type, and therefore light distribution can be broadened. Also, the amount of light traveling in the lateral direction is increased, and therefore the light distribution is easily controlled by a reflecting mirror. Further, directionality is reduced, and therefore when the light emitting device is incorporated in an illumination device, light unevenness can be made difficult to occur.

### [Brief Description of the Drawings]

[Fig. 1] Figs. 1 (a) and (b) are a side cross-sectional view and a top view of a light emitting device according to a first embodiment of the present invention, respectively.
[Fig. 2] Fig. 2 is a side cross-sectional view illustrating a light distribution curve of the same light emitting device.
[Fig. 3] Figs. 3 (a) and (b) are a side cross-sectional view and a top view illustrating a configuration using a plurality of pairs of solid-state light emitting elements and wavelength converting members in the same light emitting device, respectively.
[Fig. 4] Figs. 4 (a) and (b) are a side cross-sectional view and a top view of an illumination device incorporating the same light emitting device, respectively.
[Fig. 5] Figs. 5 (a) and (b) are side cross-sectional views illustrating a variation and another variation of the same illumination device, respectively.
[Fig. 6] Fig. 6 (a) is a side cross-sectional view of a light emitting device according to a second embodiment of the present invention, and (b) is a side cross-sectional view illustrating a light distribution curve of the same light emitting device.
[Fig. 7] Figs. 7 (a) and (b) are a side cross-sectional view and a top view of a light emitting device according to a third embodiment of the present invention, respectively.
[Fig. 8] Fig. 8 (a) is a top view illustrating a configuration using a plurality of pairs of solid-state light emitting elements and wavelength converting members in the same light emitting device, Fig. 8 (b) is a side cross sectional view along a longer direction of an illumination device incorporating the same light emitting device, Fig. 8 (c) is a side cross-sectional view along a shorter direction, and Fig. 8 (d) is a top view.
[Fig. 9] Fig. 9 is a side cross-sectional view of a light emitting device according to a fourth embodiment of the present invention.
[Fig. 10] Fig. 10 (a) is a side view of a conventional light emitting device, and Fig. 10 (b) is a diagram illustrating a light distribution curve of the light emitting device.
[Fig. 11] Fig. 11 (a) is a side cross-sectional view of an illumination device incorporating a plurality of conventional light emitting devices, and Fig. 11 (b) is diagram illustrating luminance distribution as viewed from a top surface of the same illumination device.

### [Best Mode for Carrying Out the Invention]

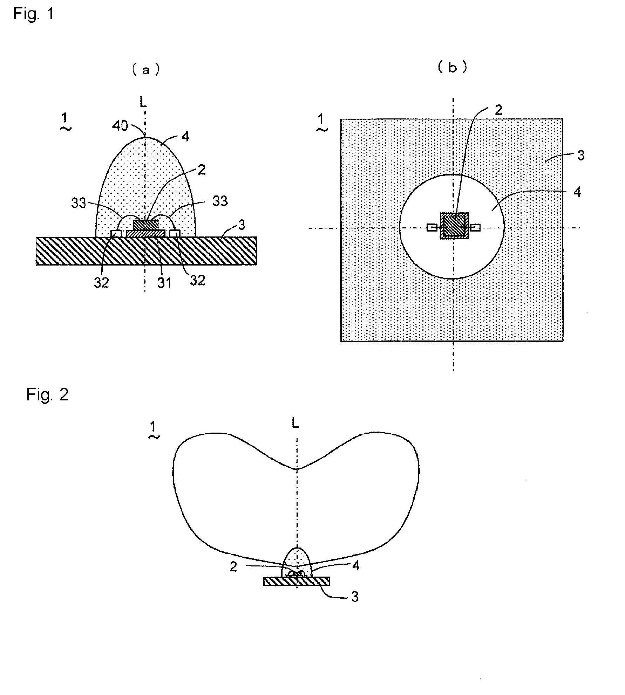

A light emitting device according to a first embodiment of the present invention and an illumination device using the light emitting device are described referring to Figs. 1 to 4. A light emitting device 1 of the present embodiment is, as illustrated in Fig. 1 (a), provided with: a light emitting diode (hereinafter referred to as an LED) 2 as a solid-state light emitting element; a wiring board (hereinafter referred to as a board) 3 on which the LED 2 is assembled; and a wavelength converting member 4 adapted to contain phosphors in a transparent resin member that covers a light emitting surface of the LED 2. The wavelength converting member 4 is, in a vertical cross-sectional view, formed so as to have an upward thickness thicker than a thickness in a lateral direction of the LED 2 and also have an apex part 40 in a light lead-out direction of the LED 2. In the following description, a normal that passes through the center of the light emitting surface of the LED 2 is referred to as a light lead-out axis L. In the present embodiment, the apex part 40 is positioned on the light lead-out axis L.

The LED 2 is not particularly limited if it is a light source that can emit light having a desired light color as the light emitting device 1; however, a GaN based blue LED chip that emits blue light having an emission peak wavelength of 460 nm is preferably used. A size of the LED 2 is also not particularly limited; however, an LED chip having a size of 0.3 square mm is preferable. In the present embodiment, as the LED 2, a so-called face-up type element of which an upper surface is provided with respective electrodes of anode and cathode is used. As an assembling method for the LED 2, the LED 2 is joined onto the board 3 by a die bond material 31, and the respective electrodes provided on the element upper surface of the LED 2 are connected to a wiring pattern 32 provided on the board 3 with use of wires 33. This causes the LED 2 and the wiring pattern 32 to be electrically connected. As the die bond material 31, for example, a silicone based resin, silver paste, other heat resistant epoxy based resin, or the like is used. Note that, here, as the assembling method for the LED 2, an example of assembling the face-up type element by wire bonding is described; however, the LED 2 may be a face-down type element of which electrodes are arranged on a lower surface side, and in this case, the LED 2 is assembled by, for example, flip-chip assembling.

For the board 3, as a base material, a general purpose plate material for board, such as a glass epoxy resin is preferably used. Alternatively, a ceramic board such as alumina or aluminum nitride, or a metal board of which a surface is provided with an insulating layer may be used. On the board 3, the wiring pattern 32 for supplying electricity to the LED 2 is provided. A size and shape of the board 3 are only required to be a size and shape that enable mounted members such as the LED 2 and the wavelength converting member 4 to be mounted, and a thickness is only required to just about have strength that prevents deformation such as deflection from occurring at the time of handling. In addition, in the case of using the above-described LED 2 having the 0.3 square mm size, a rectangular board 3 having a size of 40 mm × 40 mm is used per unit including one LED 2 and one wavelength converting member 4.

The wiring pattern 32 formed on the board 3 is formed by, for example, a method for plating an Au surface. Metal used for the plating method is not limited to Au, but may be, for example, Ag, Cu, Ni, or the like. Also, Au on the surface of each pattern part may have a stacking structure such as Au/Ni/Ag in order to increase adhesive force to the board 3. In addition, the wiring pattern 32 may be configured such that the surface thereof is subjected to a light reflection process to reflect light exiting from the LED 2 toward the board 3 side. Also, the surfaces of the board 3 and the wiring pattern 32 are preferably covered by white resist except for regions necessary to connect the wires 33 and assembling the LED 2. The white resist is formed by a method such as a lift-off method. By doing so, each pattern part is protected by the white resist, so that wiring stability is improved, and handling at the time of assembling the light emitting device 1 in the illumination device is facilitated to improve manufacturing efficiency of the device.

As the wires 33, for example, general purpose gold wires are used. Alternatively, aluminum wires, silver wires, copper wires, or the like are also possible. The wires 33 are bonded to the respective electrodes of the LED 2 and the wiring pattern 32 by a publicly known bonding method such as thermal bonding or ultrasonic bonding.

The wavelength converting member 4 is, in the present embodiment, formed in a vertically-long convex shape and also a semielliptical shape of which a vertical cross section has a major axis in a height direction, so as to, in the vertical cross-sectional view, have the upward thickness thicker than the thickness in the lateral direction of the LED 2 and also have the apex part 40 in the light lead-out direction. A ratio between the major axis and a minor axis is set to, for example, 2:1, but not limited to this.

The wavelength converting member 4 is an optical member that is fabricated by forming and processing into the above-described shape a mixed material in which in a resin material having translucency (for example, a silicone resin), particulate yellow phosphors that are excited by the blue light exiting from the LED 2 and emits yellow light are dispersed. As the resin material having translucency, for example, a silicone resin having a refractive index of 1.2 to 1.5 is used.

As the phosphors, the well known yellow phosphors that are excited by absorbing part of the blue light exiting from the LED 2, and have a peak wavelength in a wavelength range of 500 to 600 nm are preferably used. The yellow phosphors have the emission peak wavelength in the yellow wavelength range and also have an emission wavelength range including a red wavelength range. As the yellow phosphors, so-called YAG based phosphors including garnet structure crystals of composite oxide of yttrium and aluminum are cited, but without limitation to them. For example, in order to adjust a color temperature or color rendering property, or for other purpose, a plurality of different color phosphors may be mixed, and by appropriately mixing red phosphors and green phosphors, white light having a high color rendering property can be obtained. In addition, the resin material constituting the wavelength converting member 4 may be, in addition to the above phosphors, added with, for example, a light diffusing material, filler, or the like.

Methods for forming the wavelength converting member 4 include a method that, for example, fills the phosphor-containing resin in a mold formed in the above-described shape, and places the board 3 assembled with the LED 2 on an upper surface of the resin in the mold in a reversed state to cure the resin. Alternatively, a possible method is a method that prepares, with use of the phosphor-containing resin, a bowl-shaped molding provided with a concave portion as a space for placing the LED 2; fills the same resin as that of the molding in the concave portion; places the LED 2 on the board 3 so as to cover the LED 2; and cure the resin. Further, the phosphor-containing resin having relatively high thixotropy may be coated on the board 3 mounted with the LED 2 with use of a dispenser to form a desired shape. Alternatively, another possible method is a method that cuts and grinds the molding to thereby form and process the molding into the above-described shape of the wavelength converting member 4. The formed wavelength converting member 4 is, before the above-described resin is cured, bonded onto the board 3 by the resin, or after the curing, bonded onto the board 3 by a similar resin.

The light emitted from the LED 2 exits radially around the light lead-out axis L. Then, part of the light collides with the phosphors contained in the wavelength converting member 4 to cause the phosphors in a ground state to transit to an excited state. The phosphors in the excited state emit light having a different wavelength from that of the light from the LED 2 to return to the ground state. This enables the phosphors to emit the light resulting from converting the wavelength of the light from the LED 2. The light resulting from the wavelength-conversion by the phosphors radially exits from the phosphors regardless of the direction of the light lead-out axis L. That is, the light emitted from the LED 2 is not only wavelength-converted by the phosphors, but radially diffused without traveling in a traveling direction of the light emitted from the LED 2. Also, the wavelength-converted light can be further diffused by surfaces of the other phosphors.

In the present embodiment, the wavelength converting member 4 has, in the vertical cross-sectional view, the upward thickness thicker than the thickness in the lateral direction of the LED 2, and therefore from among the light emitted from the LED 2, light traveling in a light lead-out axis L direction travels the longest distance inside the wavelength converting member 4. Accordingly, the light traveling in the light lead-out axis L direction has a higher probability of colliding with the phosphors because the traveling distance (light path) inside the wavelength converting member 4 is longer, and is therefore blocked from traveling in the light lead-out axis L direction. As a result, in the vertical cross-sectional view of the wavelength converting member 4, as the upward thickness is increased further than the thickness in the lateral direction of the LED 2, an amount of the light traveling in the light lead-out axis L direction decreases. Further, the light converted by the phosphors exits as approximately diffused light distribution (e.g., BZ5 in BZ classification) with respect to an exit surface of the wavelength converting member 4. Accordingly, as a ratio of a surface area facing in the lateral direction to a surface area facing in the upward direction is increased, light distribution that is further laterally broadened is obtained.

That is, light emitted from the wavelength converting member 4 is, as illustrated in Fig. 2, emitted so as to draw a so-called batwing type light distribution curve in which an amount of luminous flux in the light lead-out axis L direction is small and an amount of luminous flux in the lateral direction is large. Accordingly, the light emitting device 1 can broaden the distribution of the light emitted from the LED 2 to reduce directionality specific to an LED light source.

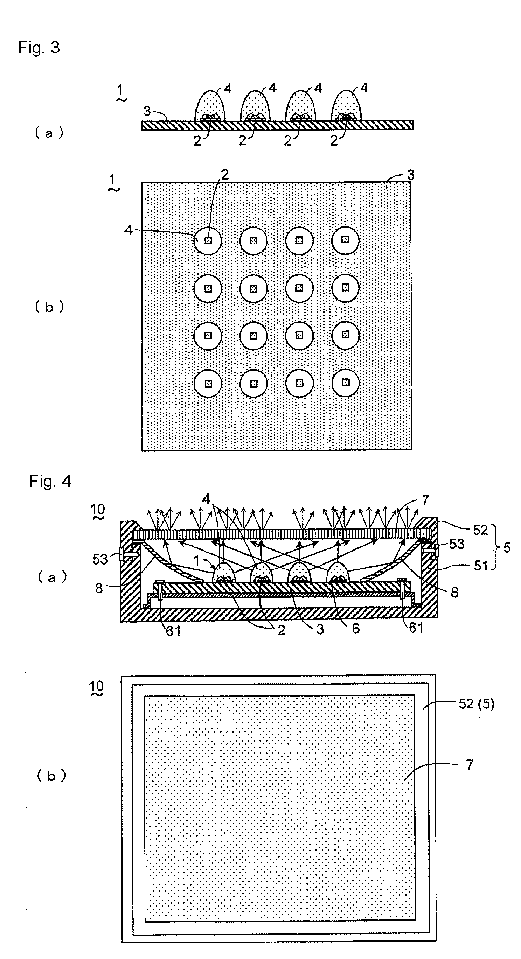

The light emitting device 1 is preferably configured such that, as illustrated in Figs. 3 (a) and (b), a plurality of pairs of LEDs 2 and wavelength converting members 4 are assembled on the board 3 in a matrix. Alternatively, without limiting to the illustrated matrix shape, the plurality of pairs of LEDs 2 and wavelength converting members 4 may be assembled on the board 3, for example, in a honeycomb or radial manner (not illustrated). Also, the plurality of LEDs 2 may be assembled on a long-sized rectangular board 3 in an array (not illustrated). Further, the present example illustrates a configuration in which each of the LEDs 2 is individually covered by the wavelength converting member 4; however, the present invention may be configured to cover the plurality of closely assembled LEDs 2 with one wavelength converting member 4.

Next, referring to Figs. 4 (a) and (b), an illumination device 10 incorporating the light emitting device 1 provided with the plurality of pairs of LEDs 2 and wavelength converting members 4 is described. The illumination device 10 is provided with: a main body part 5; an attachment plate 6 for fixing the light emitting device 1 to the main body part 5; a light diffusion transmission panel (hereinafter referred to as a light diffusing panel) 7 that is provided in the light lead-out direction of the light emitting device 1; and a reflector 8 that reflects the light emitted from the light emitting device 1 toward a light diffusing panel 7. Note that, in the present embodiment, the illumination device 10 is exemplified on the assumption of a base light having a regular rectangular shape, but may be of a long-sized rectangular shape, or a downlight having a circular shape, or the like, and a shape and the like thereof are not particular limited. Also, the light emitting device 1 incorporated in the illumination device 10 may be one including one LED 2 and one wavelength converting member 4 as illustrated in Fig. 1 (a).

The main body part 5 is provided with: an attachment frame 51 that has a bottom surface fixed with the light emitting device 1; and an opening frame 52 that is attached on an opening side of the attachment frame 51 and holds the light diffusing panel 7. The attachment frame 51 is a can-shaped structural member of which a front surface is opened, and to be able to contain the light emitting device 1, provided with: a rectangular bottom surface part that is larger than the board 3; and a side surface part that is provided upright on four sides of the bottom surface part. The side surface part of the attachment frame 51 is formed such that an outer peripheral edge on the opening side is thinner, and configured as a fitted part. By fitting the side surface part of the opening frame 52 into the fitted part and inserting screws 53 from outside, the attachment frame 51 and the opening frame 52 are fixed to each other. The opening frame 52 is a frame-shaped member of which the center is opened to emit light, and also to hold the light diffusing panel 7, configured such that a peripheral edge of an opening part protrudes inward. Also, the opening part of the opening frame 52 is larger in size than the board 3, and also formed such that, toward the light lead-out direction, an opening area is made larger. The attachment frame 51 and the opening frame 52 are fabricated by, for example, pressing a plate material having predetermined rigidity, such as an aluminum plate or a steel plate, into a predetermined shape. An inner surface of the attachment frame 51 is coated with white paint or the like.

The attachment plate 6 is a member that holds the light emitting device 1 so as to be able to form a gap between the board 3 of the light emitting device 1 and the bottom surface of the attachment frame 51, and fabricated by pressing a plate material having predetermined rigidity, such as an aluminum plate or steel plate, into the above shape. The board 3 of the light emitting device 1 and the attachment plate 6 are fixed to each other by screws 61 that penetrate through them. The attachment plate 6 is fixed to the attachment frame 51 by screws (not illustrated), adhesion, or the like. Alternatively, for example, a predetermined resin plate or clips may be used to fix an end part of the board 3 and the attachment plate 6 to each other with sandwiching them (not illustrated). The attachment plate 6 is preferably formed of a material having good thermal conductivity so as to be able to efficiently radiate heat from the light emitting device 1. Also, on a surface facing to the bottom surface of the attachment frame 51, heat radiation fins may be formed. Between the board 3 and the bottom surface of the attachment frame 51, a power source part, wirings, and the like (not illustrated) for lighting and driving the light emitting device 1 are contained. In addition, in the case of separately installing the power source, an attachment structure of the light emitting device 1 is not limited to this, and the light emitting device 1 can also be directly fixed to the bottom surface of the attachment frame 51 without intervention of the attachment plate 6.

The light diffusing panel 7 is a rectangular plate-like member fabricated by forming and processing a milky white material, which is obtained by adding diffusing particles such as titanium oxide to a translucent resin such as an acrylic resin, into substantially the same shape as an inner shape of the opening frame 52. Alternatively, the light diffusing panel 7 may be such as one fabricated by sandblasting or embossing a front or back surface of a transparent glass plate or a resin plate to form a rough surface.

The reflector 8 is one configured such that a curved plate material having reflectivity is arranged so as to surround, on all four sides, the LEDs 2 and the wavelength converting members 4, which are arranged on the board 3 in a matrix, and also slope with respect to the light lead-out axis L. As the reflector 8, a light diffuse reflector fabricated by, for example, coating highly reflective white paint on a resin structure formed in the above shape is preferably used. In addition, for example, in the case where the illumination device 10 is used as a downlight, the reflector 8 may be one that is formed in a bowl shape and has a surface on which silver or aluminum having a higher reflectance is evaporated.

In the illumination device 10 configured as described above, light emitted from the light emitting device 1 enters the light diffusing panel 7 directly or after being reflected by the reflector 8, and exits out of the illumination device 10. At this time, even in the case where the light diffusing panel 7 is arranged close to the light emitting device 1, the light emitting device 1 emits the light having the batwing light distribution as illustrated in Fig. 2, and therefore the light entering the light diffusion panel 7 has low directionality. The light is further diffused by the light diffusing panel 7 and then exits. Accordingly, the illumination device 10 can show as if a whole of the light diffusing panel 7 shines, and uniform luminance distribution of the light diffusing panel 7. Also, the light diffusing panel 7 can be arranged close to the light emitting device 1, and therefore the illumination device 10 can be made thinner. Further, on an exit surface of the light diffusing panel 7 of the illumination device 10, a sense of grains specific to the LED 2 light source can be suppressed to reduce glare.

Also, the light emitting device 1 used for the illumination device 10 is, as illustrated in Fig. 1 (b), configured such that the wavelength converting member 4 is circular in a trop view, and therefore the light isotropically exits in lateral directions of the LED 2. Accordingly, in the case where the plurality of light emitting device 1 are arranged in a matrix, the light can be evenly irradiated to the light diffusing panel 7 to uniform the luminance distribution of the light diffusing panel 7.

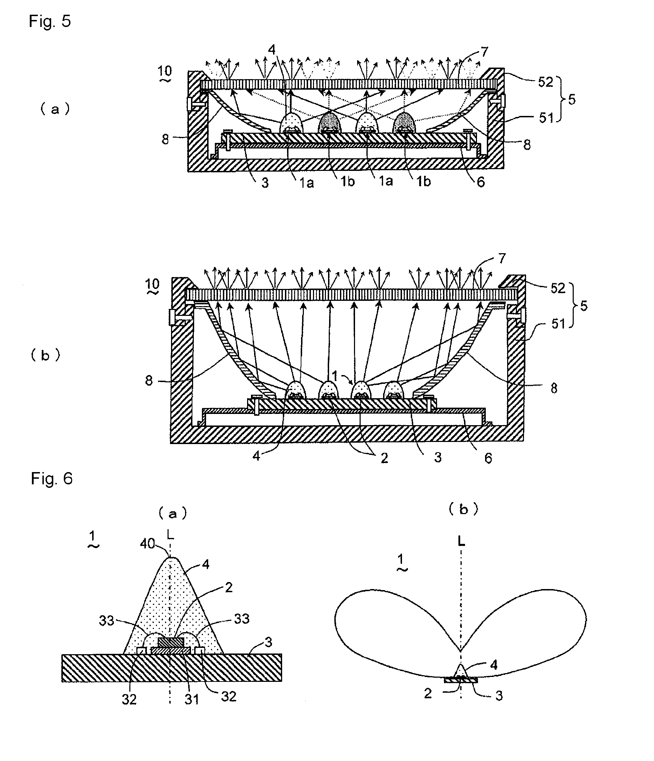

Next, variations of the illumination device 10 of the present embodiment are described referring to Figs. 5 (a) and (b). The variation illustrated in Fig. 5 (a) is one that uses light emitting devices 1 having different emission colors. Light color of exit light of each of the light emitting devices 1 is set to any chromaticity by adjusting, besides the type of a chip used for the LED 2, or the type or additive amount of phosphors used for the wavelength converting member 4, dye, paint, or the like added to the wavelength converting member 4. Light color of irradiation light of the illumination device 10 is different depending on a use environment or the like of the illumination device 10; however, in the case of a general illumination device for a living room, for example, as illustrated in the diagram, a combination of light emitting devices 1a that emit white light and light emitting devices 1b that emit electric bulb color light is cited.

In a conventional LED illumination device, lights respectively having different light colors are mixed by the light diffusing panel 7 to some extent; however, in the case where a distance between the light emitting device 1 and the light diffusing panel 7 is close, the lights may not be fully mixed, and on the exit surface of the light diffusing panel 7, color unevenness may occur. On the other hand, in this variation, the lights emitted at wide angles from the light emitting devices 1a and 1b enter an entrance surface of the light diffusing panel 7 with overlapping with each other, and then diffused by the light diffusing panel 7. Accordingly, from the exit surface of the light diffusing panel 7, light resulting from mixing the white light and the electric bulb color light uniformly exits, and thereby color unevenness of the illumination device 10 can be suppressed. Note that the color lights of the light emitting devices 1 are not limited to the above-described white light and electric bulb color light, but for example, a plurality of light emitting devices respectively emitting red (R) light, green (G) light, and blue (B) light can be used.

Also, the variation illustrated in Fig. 5 (b) is one that is provided with the reflector 8 appropriate to the type or application of the illumination device 10, and this variation illustrates a configuration that is, on the assumption of downlight illumination, provided with the reflector 8 that is larger in the light lead-out direction than that of the above-described embodiment. As described above, the illumination device 1 can emit light at wide angles, and therefore in the case of surrounding it with the reflector 8, an amount of light entering the reflector 8 becomes larger. Accordingly, by adjusting a shape or the like of a reflecting surface of the reflector 8, the illumination device 10 having high light distribution controllability can be realized.

Next, a light emitting device according to a second embodiment of the present invention and an illumination device using the light emitting device are described referring to Fig. 6. The light emitting device 1 of the present embodiment is, as illustrated in Fig. 6 (a), formed such that the wavelength converting member 4 is formed in a vertically-long triangular shape in a vertical cross-sectional view. Note that the apex part 40 of the wavelength converting member 4 is not conical or pyramidal, but formed to have a predetermined roundness. The rest of a configuration is the same as that of the above-described embodiment.

In the wavelength converting member 4, from among light emitted from the LED 2, light traveling in the light lead-out axis L direction travels long distance inside the wavelength converting member 4 and then exits, and is therefore blocked by phosphors contained in the wavelength converting member 4 from traveling in the light lead-out axis L direction. Further, light resulting from conversion by the phosphors exits as approximately diffused light distribution (BZ5) with respect to an exit surface of the wavelength converting member 4. As a result, a ratio of a surface area facing laterally is larger than that in the above first embodiment, and therefore as illustrated in Fig. 6 (b), batwing light distribution becomes more significant.

According to this configuration, in the illumination device 10 using the light emitting device 1, a distance between the light diffusing panel 7 and the light emitting device 1 can be further reduced to make the illumination device 10 thinner. Also, light distribution controllability by the reflector 8 can be further improved.

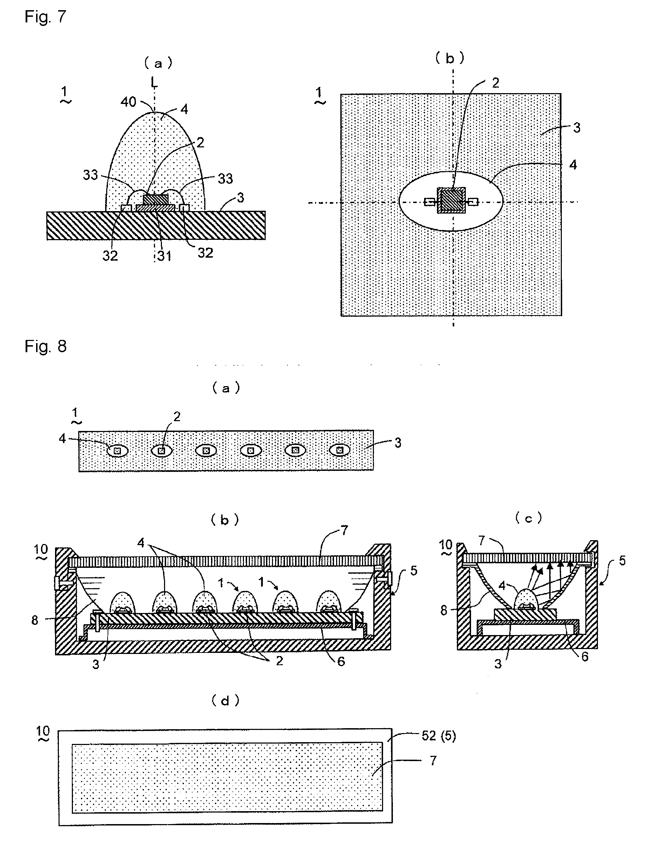

Next, a light emitting device according to a third embodiment of the present invention and an illumination device using the light emitting device are described referring to Figs. 7 and 8. The light emitting device 1 of the present embodiment is configured such that the wavelength converting member 4 is, as illustrated in Fig. 7 (a), the same as that of the above first embodiment in terms of a vertical cross sectional shape, but, as illustrated in Fig. 7 (b), formed in an elliptical shape in a top view.

In the wavelength converting member 4 formed in the elliptical shape in the top view, regarding an side surface area of the wavelength converting member 4, an area as viewed from a minor axis direction is larger than an area as viewed from a major axis direction, and therefore an amount of exit luminous flux in the minor axis direction is large as compared with that in the major axis direction.

Next, referring to Figs. 8 (a) to (d), the illumination device 10 incorporating a plurality of light emitting devices 1 respectively provided with the plurality of pairs of LEDs 2 and wavelength converting members 4 is described. In the illumination device 10, the plurality of light emitting devices 1 are, as illustrated in Fig. 8 (a), arranged on a long-sized board 3 in an array along the major axis direction of the wavelength converting members 4. Also, a pair of reflectors 8 is, as illustrated in Figs. 8 (b) and (c), arranged so as to sandwich the light emitting devices 1 that are arranged in an array along a longer direction of the long-sized board 3. The main body part 5, the attachment plate 6, and the light diffusing panel 7 are also formed respectively in long-sized shapes so as to correspond to the light emitting devices 1, and for example, a shorter side of the light diffusing panel 7 is formed more largely than a shorter side of the board 3. In addition, a plurality of lines each in which the plurality of light emitting devices 1 of the present embodiment are arranged in array may be arranged on a square shaped board 3 as illustrated in Figs. 4 (a) and (b). Also, a size of the board 3 is not particular limited, but set to, for example, a 200 mm × 20 mm long size.

In the present embodiment, if on the long-sized board 3, the plurality of light emitting devices are arranged in one line at regular intervals, an amount of light in a shorter direction of the board 3 can be increased. Based on this, in the case where an interval between adjacent lines among lines in which the plurality of light emitting devices 1 are arranged in array is large, even if the light diffusing panel 7 is arranged close to the light emitting devices 1, light unevenness does not occur in each of the lines, and therefore luminance distribution on the exit surface of the light diffusing panel 7 can be uniformed.

Next, a light emitting device according to a fourth embodiment of the present invention is described referring to Fig. 9. The light emitting device 1 of the present embodiment is configured such that the wavelength converting member 4 has a concave portion 41 on a surface facing to the LED 2, and formed as a thin member 42 having a uniform thickness, and in the concave portion 41, a transparent resin 43 is filled. The thin member 42 is a member that is formed by coating a phosphor-containing resin on the hemispherical transparent resin 43 formed to cover the LED 2, or a phosphor-containing resin member that is molded into a cap shape. A thickness of the wavelength converting member 4 (thin member 42) is set to, for example, 0.1 to 0.5 mm. As the transparent resin 43, the same resin as that constituting the thin member 42 is used except for not containing any phosphor, and for example, a silicone resin or the like is preferably used. The rest of a configuration is the same as that of the above-described embodiment.

In the case where, as described above, the shape of the wavelength converting member 4 is a semielliptical shape having a major axis upward, a difference in light path length of exit light from the LED 2 occurs inside the wavelength converting member 4, and therefore color unevenness may occur. On the other hand, by forming the thickness of the wavelength converting member 4 so as to be thin and uniform, regardless of a shape of the wavelength converting member 4, light path lengths inside the wavelength converting member 4 (thin member 42) are uniformed, and therefore the color unevenness can be suppressed. In addition, the wavelength converting member 4 is preferably formed to have a higher phosphor concentration near the apex part 40.

Note that the present invention is configured to, with use of the wavelength converting member 4 that converts a wavelength of exit light from the LED 2, broaden light distribution of exit light; however, without limitation to any of the above embodiments, various modifications are possible. For example, outside the wavelength converting member 4, another optical member that adjusts light distribution may be further provided.

### [Description of Reference Numerals]

1: Light emitting device
10: Illumination device
2: LED (solid-state light emitting element)
4: Wavelength converting member
40: Apex part
41: Concave portion
42: Thin member
43: Transparent resin

## Claims

1. A light emitting device comprising:
a solid-state light emitting element; and
a wavelength converting member that is adapted to contain a phosphor in a transparent resin member that covers a light emission surface of the solid-state light emitting element, wherein
the wavelength converting member is, in a vertical cross-sectional view, formed so as to have an upward thickness thicker than a thickness in a lateral direction of the solid-state light emitting element and also have an apex part in a light lead-out direction of the solid-state light emitting element.

2. The light emitting device according to claim 1, wherein
the wavelength converting member is, in the vertical cross-sectional view, formed in a vertically-long convex shape.

3. The light emitting device according to claim 1, wherein
the wavelength converting member is, in the vertical cross-sectional view, formed in a vertically-long triangular shape.

4. The light emitting device according to any one of claims 1 to 3, wherein
the wavelength converting member is, in a top view, formed in a circular shape.

5. The light emitting device according to any one of claims 1 to 3, wherein
the wavelength converting member is, in a top view, formed in an elliptical shape.

6. The light emitting device according to any one of claims 1 to 3, wherein
the wavelength converting member has a concave portion on a surface facing to the solid-state light emitting element and is formed as a thin member having a uniform thickness, and in the concave portion, a transparent resin is filled.

7. The light emitting device according to claim 6, wherein
the thin member is made of phosphor-containing resin that is coated or molded into a cap shape.

8. An illumination device using the light emitting device according to any one of claims 1 to 7.
